# EUROPÄISCHE PATENTSCHRIFT

(11) **EP 3 139 188 B1**
(45) Veröffentlichungstag und Bekanntmachung des Hinweises auf die Patenterteilung: **20.11.2019**
(21) Anmeldenummer: 16186095.2
(22) Anmeldetag: 29.08.2016
(51) Int. Cl.: G01R 27/18, G01R 31/02, G01R 31/08, G01R 31/14

(54) **VERFAHREN UND VORRICHTUNG ZUR ISOLATIONSFEHLERSUCHE MIT ADAPTIVER PRÜFSTROM-ERMITTLUNG**
METHOD AND DEVICE FOR ISOLATION TROUBLESHOOTING WITH ADAPTIVE TEST CURRENT DETERMINATION
PROCÉDÉ ET DISPOSITIF DE RECHERCHE D'ERREUR D'ISOLATION COMPRENANT UNE DÉTERMINATION ADAPTATIVE DE COURANT DE TEST

(30) Priorität: 03.09.2015 DE 102015216915
(43) Veröffentlichungstag der Anmeldung: 08.03.2017
(73) Patentinhaber: Bender GmbH & Co. KG, 35305 Grünberg (DE)
(72) Erfinder: HACKL, Dieter, 35463 Fernwald (DE); SCHÄFER, Oliver, 35305 Grünberg (DE)
(74) Vertreter: advotec.

(56) Entgegenhaltungen:
- EP-A1- 1 593 983
- EP-A1- 2 664 932
- EP-A1- 2 851 692

## Beschreibung

Die Erfindung betrifft ein Verfahren zur Isolationsfehlersuche in einem IT-Stromversorgungssystem, umfassend die Verfahrensschritte: Einspeisen eines Prüfstroms, Erfassen eines Prüfstromanteils in einem Abzweig des IT-Stromversorgungssystems und Auswerten des erfassten Prüfstromanteils.

Weiterhin betrifft die Erfindung ein Isolationsfehlersuchsystem für ein IT-Stromversorgungssystem mit einem Prüfstromgenerator zur Einspeisung eines Prüfstroms, mit einem Prüfstromsensor zur Erfassung eines Prüfstromanteils in einem Abzweig des IT-Stromversorgungssystems und mit einem Auswertegerät zur Auswertung des erfassten Prüfstromanteils.

Durch die inhärente Sicherheit von IT-Stromversorgungssystemen (frz. Isolé Terre - IT) kann eine kontinuierliche Stromversorgung der von dem IT-Stromversorgungsystem gespeisten Verbraucher auch dann gewährleistet werden, wenn ein erster Isolationsfehler auftritt, da die aktiven Teile des IT-Stromversorgungssystems von dem Erdpotenzial - gegenüber "Erde" - getrennt sind und sich in diesem ersten Fehlerfall kein geschlossener Stromkreis ausbilden kann. Ein erster Isolationsfehler liegt beispielsweise dann vor, wenn zwischen einem aktiven Leiter des IT-Stromversorgungssystems und dem leitfähigen Gehäuse eines Betriebsmittels (Verbrauchers) eine unbeabsichtigte elektrische Verbindung besteht.

Unter der Voraussetzung, dass der Isolationszustand des IT-Stromversorgungssystems kontinuierlich von einem Isolationsüberwachungsgerät überwacht wird, kann das IT-Stromversorgungssystem auch bei einem aufgetretenen ersten Fehler ohne vorgeschriebene Zeitlimitierung weiterbetrieben werden, jedoch gilt gemäß den Normen DIN VDE 0100-410 bzw. IEC 60364-4-41 die Empfehlung, den ersten Fehler so schnell wie praktisch möglich zu beseitigen.

Ein erster Isolationsfehler wird von dem Isolationsüberwachungsgerät erkannt und gemeldet. Mit dieser Meldung startet eine Isolationsfehlersuche, indem ein Prüfsignalgenerator eines Isolationsfehlersuchsystems einen Prüfstrom erzeugt und an zentraler Stelle in das IT-Stromversorgungssystem einspeist. In den in die Fehlersuche miteinbezogenen Abzweigen des IT-Stromversorgungssystems erfasst dann ein Prüfstromsensor, ob in dem jeweiligen Abzweig ein signifikanter Prüfstromanteil fließt.

Die Signale der Prüfstromsensoren werden zentral in einem Auswertegerät erfasst und auf Basis dieser Signale wird eine Isolationsfehlerlokalisierung durchgeführt.

Gemäß dem Stand der Technik werden die Prüfstrom-Parameter, insbesondere die Prüfstrom-Amplitude und bei pulsförmigem Prüfstrom auch die Prüfstrom-Pulsdauer, des von dem Isolationsfehlersuchsystem erzeugten und eingespeisten Prüfstroms bei der Planung und Installation der sicherheitstechnischen Maßnahmen für das IT-Stromversorgungssystem einmalig festgelegt. Hierbei ist ein Kompromiss zwischen den folgenden Anforderungen zu finden: (1) Vermeidung einer Personengefährdung und Vermeidung von Brandgefahren durch den Prüfstrom, (2) keine Beeinträchtigung der Funktion des IT-Stromversorgungssystems und der angeschlossenen Betriebsmittel durch den Prüfstrom und (3) Lokalisierung auch möglichst hochohmiger Isolationsfehler.

In der Praxis wird die Prüfstrom-Amplitude auf einige 10 mA oder sogar nur wenige mA begrenzt, um die Anforderungen (1) und (2) sicher zu erfüllen.

Insbesondere in weitverzweigten IT-Stromversorgungssystemen können Probleme wegen der Größe und/oder der Verteilung von Netzableitkapazitäten auftreten. Diese Netzableitkapazitäten liegen meistens elektrisch parallel zu den zu detektierenden Fehlerwiderständen. Ein Teil des Prüfstroms fließt daher durch diese Kapazitäten und führt bei einem zu niedrig festgelegtem Prüfstrom dazu, dass hochohmige Fehlerwiderstände im ungünstigsten Fall nicht entdeckt werden. Ein weiteres Problem stellt die Verteilung des Prüfstroms auf sehr viele fehlerbehaftete Abzweige in einem schlecht gewarteten IT-Stromversorgungssystem dar. Mehrfachfehler sind mit kleinen Prüfstrom-Amplituden sehr schwierig zu detektieren, da sich der geringe Prüfstrom auf mehrere Fehlerwiderstände verteilt und die Empfindlichkeitsschwelle der Prüfstromsensoren unterschritten werden kann. Schließlich können in IT-Stromversorgungssystemen Störkomponenten auftreten, die eine Isolationsfehlersuche erschweren oder verhindern, falls der Prüfstromanteil in dem fehlerhaften Abzweig so gering ist, dass dieser von Störsignalen überdeckt wird und von dem Prüfstromsensor nicht oder nicht hinreichend genau erfasst werden kann.

Die genannten Umstände können somit zur Folge haben, dass ein Isolationsfehler nicht lokalisiert werden kann.

Bekannte Maßnahmen zur Lösung der Problematik bestehen zum einen in einer manuellen Anpassung der Prüfstrom-Parameter, beispielsweise in einer manuellen Erhöhung der Prüfstrom-Amplitude, soweit dies in dem installierten Isolationsfehlersuchsystem möglich ist. Da aber die Abschätzung einer maximal zulässigen Prüfstrom-Amplitude in einem aktuell vorliegenden Fehlerfall erhebliche Fachkompetenz erfordert, wird hierzu meist speziell geschultes Servicepersonal mit der Fehlersuche beauftragt. Die Instandhaltungsmaßnahmen werden dadurch in nachteiliger Weise verzögert und verteuert. Zum anderen kann als weitere Maßnahme das Isolationsfehlersuchsystem oder Komponenten des installierten Isolationsfehlersuchsystems gegen ein System mit einer höheren Prüfstrom-Amplitude ausgetauscht werden, sofern ein solches System auf dem Markt verfügbar ist. Häufig erfordert ein Austausch solcher Komponenten in kritischen IT-Stromversorgungssystemen eine erneute Abnahme durch einen Sachverständigen.

Als nachteilig erweist sich weiterhin, dass die Prüfstrom-Amplituden von derzeit verfügbaren Isolationsfehlersuchsystemen herstellerseitig meist auf niedrige Werte von einigen 10 mA begrenzt werden. So verbleibt in den genannten problematischen Fällen nur die Möglichkeit, die Fehlersuche ohne Hilfe von Isolationsfehlersuchsystemen, z. B. durch Abschaltung von Abzweigen (Subsystemen), durchzuführen.

Die genannten Lösungen sind daher in der Praxis nicht immer zufriedenstellend. Zudem kann eine Verzögerung bei der Lokalisierung und Beseitigung eines ersten Fehlers zu einer unnötigen Belastung des IT-Stromversorgungssystems oder sogar zu einer Abschaltung der Stromversorgung führen.

Isolationsfehlersuchsysteme sind aus EP1593983, EP2851692 und EP2664932 bekannt.

Der vorliegenden Erfindung liegt somit die Aufgabe zu Grunde, ein Verfahren und eine Vorrichtung zur Isolationsfehlersuche derart weiterzuentwickeln, dass eine zuverlässige Isolationsfehlerlokalisierung wirtschaftlich vertretbar erfolgen kann, wobei gleichzeitig eine hohe elektrische Sicherheit gewährleistet ist.

Diese Aufgabe wird bezogen auf ein Verfahren in Verbindung mit dem Oberbegriff des Anspruchs 1 dadurch gelöst, dass ein Prüfstrom-Parameter des Prüfstroms in Abhängigkeit eines elektrischen Systemparameters des IT-Stromversorgungssystems adaptiv ermittelt wird, wobei als Systemparameter eine Verteilung des Isolationswiderstands des IT-Stromversorgungssystems auf einzelne Leiterphasen ausgewertet wird.

Der Grundgedanke der vorliegenden Erfindung beruht darauf, mindestens einen kennzeichnenden Parameter des Prüfstroms, insbesondere die Stromamplitude und die Strom-(signal-)form automatisch so an das IT-Stromversorgungssystem anzupassen, dass ein gemäß den oben genannten Anforderungen (1) bis (3) optimal zur Fehlersuche geeigneter Prüfstrom eingespeist wird. In Abhängigkeit, d. h. unter Berücksichtigung und Auswertung mindestens eines elektrischen Systemparameters des IT-Stromversorgungssystems wird der Prüfstrom automatisch auf Anforderung oder in festgelegten Aktualisierungsintervallen an die Konfiguration und den elektrischen Zustand des IT-Stromversorgungssystems angepasst.

In weiterer Ausgestaltung wird als Prüfstrom-Parameter eine Prüfstrom-Amplitude adaptiv ermittelt.

Ein Parameter zur Beschreibung des Prüfstroms ist seine Amplitude (Prüfstrom-Amplitude). Diese Prüfstrom-Amplitude wird automatisch entsprechend einer vorgegebenen Rechenvorschrift in Abhängigkeit eines elektrischen Systemparameters des IT-Stromversorgungssystems, vorzugsweise in Abhängigkeit der Größe des Isolationswiderstands, ermittelt.

Dadurch wird erreicht, dass ein optimal zur Fehlersuche benötigter maximaler Prüfstrom zum Einsatz kommen kann, ohne eine Gefährdung für Personen oder Anlagenteile hervorzurufen.

Weiterhin wird als Prüfstrom-Parameter eine Prüfstrom-Pulsdauer eines pulsförmigen Prüfstroms adaptiv ermittelt.

Ein weiterer Parameter zur Beschreibung des Prüfstroms stellt bei einem pulsförmigen Prüfstrom die Prüfstrom-Pulsdauer dar. In Abhängigkeit mindestens eines elektrischen Systemparameters des IT-Stromversorgungssystems wird die Prüfstrom-Pulsdauer adaptiv ermittelt - vorzugsweise in Abhängigkeit der Größe und Verteilung der Netzableitkapazitäten, um deren vollständige Aufladung zu ermöglichen und die Messung in eingeschwungenem Zustand vornehmen zu können.

Daraus resultiert eine zeitoptimierte Ermittlung des Fehlerortes in Verbindung mit der Möglichkeit, auch hochohmige Isolationsfehler erkennen zu können.

Mit Vorteil erfolgt eine gezielte Einspeisung eines Prüfstroms in eine Leiterphase des IT-Stromversorgungssystems.

Die gezielte Einspeisung des Prüfstroms in eine Leiterphase ermöglicht die Verwendung eines maximalen Prüfstroms, ohne dass die Funktion des IT-Stromversorgungssystems nachteilig beeinflusst wird. Dabei kann die gezielte Einspeisung auch in einer gewichteten Aufteilung des (Gesamt-) Prüfstroms bestehen, wobei für jede Leiterphase des IT-Stromversorgungssystems der Prüfstrom adaptiv so ermittelt wird, dass ein hinsichtlich seiner Amplitude maximaler Prüfstrom mit optimal angepasster Prüfstrom-Pulsdauer eingespeist wird, ohne dass eine Personengefährdung oder eine Funktionsbeeinträchtigung eintritt.

Als elektrischer Systemparameter kann zusätzlich eine oder mehrere der folgenden Kenngrößen des IT-Stromversorgungssystems ausgewertet werden: Isolationswiderstand, Netzableitkapazität, momentane Verlagerungsspannung, maximal zulässige Verlagerungsspannung, maximal zulässige Wirkleistung in einem Fehlerwiderstand, Zeitbegrenzung für das Fließen eines maximalen Prüfstroms.

Als weiterer elektrischer Systemparameter wird eine oder mehrere der folgenden netztechnischen Angaben ausgewertet: systemrelevante Normvorgaben, Vorgaben der Systemauslegung, sicherheitskritische Einstufung.

In bevorzugter Ausgestaltung wird der elektrische Systemparameter statisch konfiguriert oder dynamisch ermittelt.

Als statisch konfigurierter elektrischer Systemparameter ist die auszuwertende Kenngröße oder Angabe als fester Wert in einem Speicher hinterlegt. Die dynamische Ermittlung des elektrischen Systemparameters kann durch direkte Messung oder durch Datenübertragung einer bereits ermittelten Kenngröße, beispielsweise durch Kommunikation des Isolationswiderstandswertes über eine Datenverbindung von einem Isolationsüberwachungsgerät aus, erfolgen.

Vorteilhaft ist mittels eines Computerprogramms ein Ablauf der adaptiven Ermittlung des Prüfstrom-Parameters festgelegt.

Die adaptive Ermittlung des Prüfstrom-Parameters erfolgt softwaretechnisch gesteuert durch Programmanweisungen. Dies eröffnet die Möglichkeit, flexibel auf Änderungen an dem IT-Stromversorgungssystem oder auf geänderte Anforderungen reagieren zu können.

Eine mögliche Vorgehensweise, um beispielsweise die optimale zur Fehlersuche benötigte Prüfstrom-Amplitude einzustellen, besteht darin, die Prüfstrom-Amplitude langsam zu erhöhen, bis ein Auswertegerät einen fehlerhaften Abzweig detektiert hat oder die maximal zulässige Prüfstrom-Amplitude erreicht wurde oder ein anderer relevanter elektrischer Systemparameter des IT-Stromversorgungssystems erreicht wird, der eine weitere Steigerung der Prüfstrom-Amplitude verbietet.

Das Computerprogramm greift auf eine Fach-Wissensbasis zu und stellt unter Einbeziehung des elektrischen Systemparameters den Prüfstrom-Parameter adaptiv ein oder schlägt den ermittelten Prüfstrom-Parameter zur Verwendung vor.

In dem Isolationsfehlersuchsystem wird dabei abrufbares Fachwissen über ein optimales Vorgehen für die Isolationsfehlersuche abgelegt, welches die bekannten relevanten elektrischen Systemparameter des IT-Stromversorgungssystems nutzt, um den optimalen zur Fehlersuche benötigten Prüfstrom-Parameter automatisiert einzustellen oder den ermittelten Parameterwert dem Anwender zur Verwendung vorzuschlagen.

Bezogen auf eine Vorrichtung wird die Aufgabe in Verbindung mit dem Oberbegriff des Anspruchs 10 dadurch gelöst, dass das Isolationsfehlersuchsystem eine Recheneinheit zur adaptiven Ermittlung eines Prüfstrom-Parameters in Abhängigkeit eines elektrischen Systemparameters des IT-Stromversorgungssystems aufweist, wobei als elektrischer Systemparameter eine Verteilung des Isolationswiderstands auf einzelne Leiterphasen ausgewertet wird.

In Umsetzung des erfindungsgemäßen Verfahrens besitzt das Isolationsfehlersuchsystem erfindungsgemäß eine Recheneinheit, die eine software-technische Implementierung der adaptiven Parameter-Ermittlung umfasst.

Das erfindungsgemäße Isolationsfehlersuchsystem und das dem Isolationsfehlersystem zugrunde liegende Verfahren ermöglichen es, ohne weitere Fachkenntnisse des Bedienpersonals einen adaptiv ermittelten und optimal zur Fehlersuche geeigneten Prüfstrom zu einzuspeisen.

Die erzielte Vereinfachung bei der Durchführung der Isolationsfehlersuche führt zu einer erhöhten Sicherheit bei dem Betrieb und der Instandhaltung eines IT-Stromversorgungssystems, da die Fehlerlokalisierung schneller erfolgt und daher Gefahren vermieden werden können, die durch einen Isolationsfehler entstehen. Damit gestaltet sich die Isolationsfehlersuche insbesondere in komplexen IT-Stromversorgungssystemen deutlich zuverlässiger und wirtschaftlicher.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: ein erfindungsgemäßes Isolationsfehlersuchsystem und
- **Fig. 2:**: schematisch das Prinzip der adaptiven Ermittlung eines Prüfstrom-Parameters gemäß dem erfindungsgemäßen Verfahren.

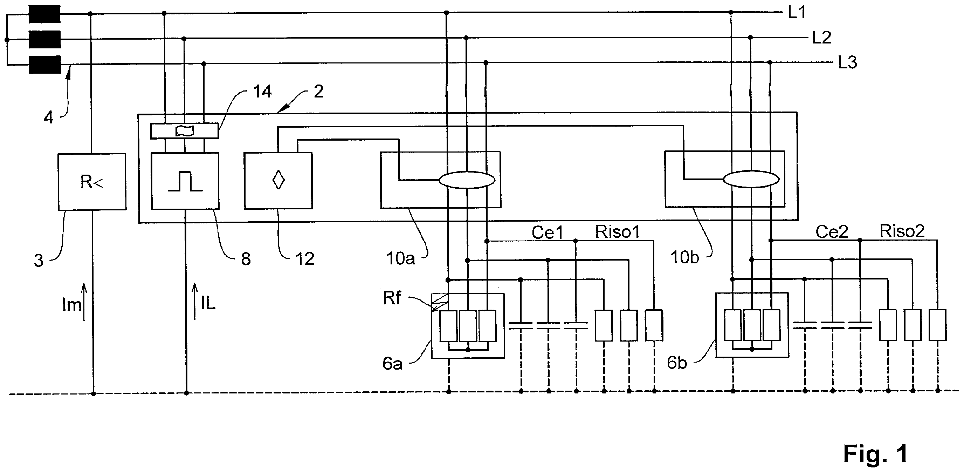

**Fig. 1** zeigt ein erfindungsgemäßes Isolationsfehlersuchsystem 2 in einem dreiphasigen IT-Stromversorgungssystem 4 mit zwei Abzweigen, die jeweils einen Verbraucher 6a, 6b versorgen. Das IT-Stromversorgungssystem 4 ist weiterhin gekennzeichnet durch die Ableitkapazitäten Ce1, Ce2 und die Isolationswiderstände Riso1, Riso2.

Das IT-Stromversorgungssystem 4 wird von einem Isolationsüberwachungsgerät 3 überwacht, welches zur Bestimmung des Gesamt-Isolationswiderstands des IT-Stromversorgungssystems 4 einen Messstrom Im in das IT-Stromversorgungssystem 4 einprägt.

Das Isolationsfehlersuchsystem 2 umfasst einen Prüfstromgenerator 8, der einen von dem Messstrom Im des Isolationsüberwachungsgerätes 3 unabhängigen Prüfstrom IL zwischen den spannungsführenden Leitern L1, L2, L3 und Erde PE in das IT-Stromversorgungsystem 4 einprägt. In den Abzweigen des IT-Stromversorgungssystems 4 ist jeweils ein Prüfstromsensor 10a, 10b angeordnet, der einen in dem Abzweig fließenden Prüfstromanteil erfasst. Liegt nun, wie in Fig. 1 dargestellt, ein Isolationsfehler Rf an dem Verbraucher 6a vor, so ist der von dem Prüfstromsensor 10a erfasste Prüfstromanteil in diesem fehlerbehafteten Abzweig ungleich Null und der Prüfstromsensor 10a sendet ein entsprechendes Messsignal an ein Auswertegerät 12. Das Auswertegerät 12 empfängt die Messsignale aller Prüfstromsensoren 10a, 10b und lokalisiert anhand der Zuordnung Prüfstromsensor/Abzweig den Fehlerort.

Erfindungsgemäß weist das Isolationsfehlersuchsystem 2 eine Recheneinheit 14 auf, die adaptiv den Prüfstrom IL, insbesondere dessen kennzeichnende Parameter Prüfstrom-Amplitude und Prüfstrom-Pulsdauer, ermittelt.

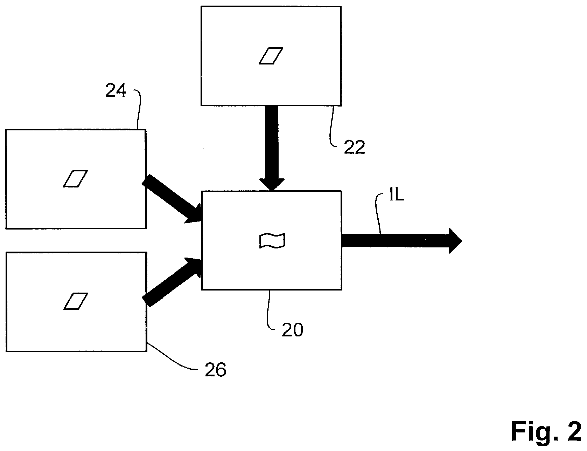

Das Prinzip der adaptiven Ermittlung eines Prüfstrom-Parameters des Prüfstroms IL gemäß dem erfindungsgemäßen Verfahren ist in **Fig. 2** dargestellt. Zentrales Element bildet ein Computerprogramm 20, welches die adaptive Ermittlung mittels Programmanweisungen ausführt. Dabei greift das Computerprogramm 20 auf eine Fach-Wissensbasis 22 zu, die Handlungsvorschriften über eine für den aufgetretenen Betriebsfall optimale, d. h. zuverlässige und schnelle, Vorgehensweise enthält. Um auf der Grundlage dieser Vorgehensweise einen geeigneten Prüfstrom zu ermitteln, nutzt das Computerprogramm 20 statisch konfigurierte elektrische Systemparameter 24 und/oder dynamisch ermittelte elektrische Systemparameter 26 des IT-Stromversorgungssystems 4.

## Patentansprüche

1. Verfahren zur Isolationsfehlersuche in einem IT-Stromversorgungssystem (4), umfassend die Verfahrensschritte:
- Einspeisen eines Prüfstroms (IL),
- Erfassen eines Prüfstromanteils in einem Abzweig des IT-Stromversorgungssystems (4),
- Auswerten des erfassten Prüfstromanteils,
**gekennzeichnet durch**
- adaptives Ermitteln eines Prüfstrom-Parameters des Prüfstroms (IL) in Abhängigkeit eines elektrischen Systemparameters (24, 26) des IT-Stromversorgungssystems (4), wobei als elektrischer Systemparameter (24, 26) eine Verteilung eines Isolationswiderstands des IT-Stromversorgungssystems (4) auf einzelne Leiterphasen ausgewertet wird.

2. Verfahren nach Anspruch 1,
**dadurch gekennzeichnet,**
**dass** als Prüfstrom-Parameter eine Prüfstrom-Amplitude adaptiv ermittelt wird.

3. Verfahren nach Anspruch 1 oder 2,
**dadurch gekennzeichnet,**
**dass** als Prüfstrom-Parameter eine Prüfstrom-Pulsdauer eines pulsförmigen Prüfstroms (IL) adaptiv ermittelt wird.

4. Verfahren nach einem der Ansprüche 1 bis 3,
**dadurch gekennzeichnet,**
**dass** eine gezielte Einspeisung eines Prüfstroms (IL) in eine Leiterphase (L1, L2, L3) des IT-Stromversorgungssystems (4) erfolgt.

5. Verfahren nach einem der Ansprüche 1 bis 4,
**dadurch gekennzeichnet,**
**dass** als elektrischer Systemparameter (24, 26) eine oder mehrere der folgenden Kenngrößen des IT-Stromversorgungssystems (4) ausgewertet wird: Isolationswiderstand, Netzableitkapazität, momentane Verlagerungsspannung, maximal zulässige Verlagerungsspannung, maximal zulässige Wirkleistung in einem Fehlerwiderstand, Zeitbegrenzung für das Fließen eines maximalen Prüfstroms.

6. Verfahren nach einem der Ansprüche 1 bis 5,
**dadurch gekennzeichnet,**
**dass** als elektrischer Systemparameter (24, 26) eine oder mehrere der folgenden netztechnischen Angaben ausgewertet wird: systemrelevante Normvorgaben, Vorgaben der Systemauslegung, sicherheitskritische Einstufung.

7. Verfahren nach einem der Ansprüche 1 bis 6,
**dadurch gekennzeichnet,**
**dass** der elektrische Systemparameter (24, 26) statisch konfiguriert wird oder dynamisch ermittelt wird.

8. Verfahren nach einem der Ansprüche 1 bis 7,
**dadurch gekennzeichnet,**
**dass** mittels eines Computerprogramms (20) ein Ablauf der adaptiven Ermittlung des Prüfstrom-Parameters festgelegt ist.

9. Verfahren nach Anspruch 8,
**dadurch gekennzeichnet,**
**dass** das Computerprogramm (20) auf eine Fach-Wissensbasis (22) zugreift und unter Einbeziehung des elektrischen Systemparameters (24, 26) den Prüfstrom-Parameter adaptiv einstellt oder den ermittelten Prüfstrom-Parameter zur Verwendung vorschlägt.

10. Isolationsfehlersuchsystem für ein IT-Stromversorgungssystem (4) mit einem Prüfstromgenerator (8) zur Einspeisung eines Prüfstroms (IL), mit einem Prüfstromsensor (10a, 10b) zur Erfassung eines Prüfstromanteils in einem Abzweig des IT-Stromversorgungssystems (4), mit einem Auswertegerät (12) zur Auswertung des erfassten Prüfstromanteils,
**gekennzeichnet durch**
eine Recheneinheit (14) zur adaptiven Ermittlung eines Prüfstrom-Parameters in Abhängigkeit eines elektrischen Systemparameters (24, 26) des IT-Stromversorgungssystems (4), wobei als elektrischer Systemparameter (24, 26) eine Verteilung des Isolationswiderstands auf einzelne Leiterphasen ausgewertet wird.

## Claims

1. Method for insulation fault location in an IT power supply system (4), comprising the process steps:
- supplying of a test current (IL),
- detecting of a test current portion in a branch of the IT power supply system (4),
- evaluating the detected test current portion,
**characterised by**
- adaptive determining of a test current parameter of the test current (IL) depending on an electric system parameter (24, 26) of the IT power supply system (4), a distribution of an insulation resistance of the IT power supply system (4) on individual conductor phases being evaluated as the electric system parameter (24, 26).

2. Method according to claim 1,
**characterised in that**
a test current amplitude is adaptively determined as a test current parameter.

3. Method according to claim 1 or 2,
**characterised in that**
a test current pulse duration of a pulse-shaped test current (IL) is adaptively determined as a test current parameter.

4. Method according to any one of the claims 1 to 3,
**characterised in that**
a specific supply of a test current (IL) in a conductor phase (L1, L2, L3) of the IT power supply system (4) is carried out.

5. Method according to any one of the claims 1 to 4,
**characterised in that**
one or more of the following parameters of the IT power supply system (4) are evaluated as electric system parameters (24, 26): insulation resistance, network leakage capacitance, momentary displacement voltage, maximum admissible displacement voltage, maximum admissible active power in a fault resistance, time limitation for the flow of a maximum test current.

6. Method according to any one of the claims 1 to 5,
**characterised in that**
one or more of the following network-related specifications are evaluated as electric system parameters (24, 26): system-relevant standards, specifications of the system configuration, safety-critical categorisation.

7. Method according to any one of the claims 1 to 6,
**characterised in that**
the electric system parameter (24, 26) is statically configured or dynamically determined.

8. Method according to any one of the claims 1 to 7,
**characterised in that**
a sequence of the adaptive determination of the test current parameter is set by means of a computer program (20).

9. Method according to claim 8,
**characterised in that**
the computer program (20) accesses an expert knowledge base (22) and adaptively adjusts the test current parameter or proposes the determined test current parameter for use, taking into account the electric system parameter (24, 26).

10. Insulation fault location system for an IT power supply system (4) having a test current generator (8) for supplying a test current (IL), having a test current sensor (10a, 10b) for detecting a test current portion in a branch of an IT power supply system (4), having an analysing device (12) for evaluating the detected test current portion,
**characterised by**
a computing unit (14) for adaptively determining a test current parameter depending on an electric system parameter (24, 26) of the IT power supply system (4), a distribution of the insulation resistance of the IT power supply system (4) on individual conductor phases being evaluated as the electric system parameter (24, 26).

## Revendications

1. Procédé de localisation de défauts d'isolement pour un système d'alimentation électrique IT (4), comprenant les étapes de procédé consistant à:
- alimentation d'un courant d'essai (IL),
- détection d'une part du courant d'essai dans une dérivation du système d'alimentation électrique IT (4),
- évaluation de la part du courant d'essai détectée,
**caractérisé par**
- la détermination adaptive d'un paramètre de courant d'essai du courant d'essai (IL) en fonction d'un paramètre de système (24, 26) électrique du système d'alimentation électrique IT (4), une distribution d'une résistance d'isolement du système d'alimentation électrique IT (4) sur des phases de conducteur séparées étant évaluée comme paramètre de système (24, 26) électrique.

2. Procédé selon la revendication 1,
**caractérisé en ce**
**qu'**une amplitude de courant d'essai est déterminée de manière adaptive comme paramètre de courant d'essai.

3. Procédé selon la revendication 1 ou 2,
**caractérisé en ce**
**qu'**une durée d'impulsion de courant d'essai d'un courant d'essai (IL) en forme d'impulsion est déterminée de manière adaptive comme paramètre de courant d'essai.

4. Procédé selon l'une quelconque des revendications 1 à 3,
**caractérisé en ce**
**qu'**un courant d'essai (IL) est alimenté de manière ciblée dans une phase de conducteur (L1, L2, L3) du système d'alimentation électrique IT (4).

5. Procédé selon l'une quelconque des revendications 1 à 4,
**caractérisé en ce**
**qu'**une ou plusieurs des caractéristiques spécifiques suivantes du système d'alimentation électrique IT (4) est/sont évaluée/s comme paramètre de système (24, 26) électrique: la résistance d'isolement, la capacité de fuite de réseau, une tension résiduelle instantanée, une tension résiduelle maximale, une puissance active maximale dans une résistance de défaut, une limitation de temps pour la circulation d'un courant d'essai maximal.

6. Procédé selon l'une quelconque des revendications 1 à 5,
**caractérisé en ce**
**qu'**une ou plusieurs des spécifications suivantes en relation au réseau est/sont évaluée/s comme paramètre de système (24, 26) électrique: des normes importantes pour le système, des spécifications de la conception du système, un classement concernant la sécurité.

7. Procédé selon l'une quelconque des revendications 1 à 6,
**caractérisé en ce que**
le paramètre de système (24, 26) électrique est configuré de manière à être statique ou déterminé de manière dynamique.

8. Procédé selon l'une quelconque des revendications 1 à 7,
**caractérisé en ce**
**qu'**un déroulement de la détermination adaptive du paramètre de courant d'essai est prédéfini moyennant un programme d'ordinateur (20).

9. Procédé selon la revendication 8,
**caractérisé en ce que**
le programme d'ordinateur (20) accède à une base de connaissances spécialisée (22) et règle le paramètre de courant d'essai de manière adaptive ou propose le paramètre de courant d'essai déterminé pour être utilisé en tenant compte du paramètre de système (24, 26) électrique.

10. Système de localisation de défauts d'isolement pour un système d'alimentation électrique IT (4), ayant un générateur de courant d'essai (8) pour alimenter un courant d'essai (IL), ayant un capteur de courant d'essai (10a, 10b) pour détecter une part de courant d'essai dans une dérivation du système d'alimentation électrique IT (4), ayant un appareil d'évaluation (12) pour évaluer la part de courant d'essai détectée,
**caractérisé par**
une unité de calcul (14) pour la détermination adaptive d'un paramètre de courant d'essai en fonction d'un paramètre de système (24, 26) électrique du système d'alimentation électrique IT (4), une distribution de la résistance d'isolement du système d'alimentation électrique IT (4) sur des phases de conducteur séparées étant évaluée comme paramètre de système (24, 26) électrique.
